# EUROPEAN PATENT APPLICATION

(11) **EP 0 935 298 A2**
(43) Date of publication of application: **11.08.1999**
(21) Application number: 99200319.4
(22) Date of filing: 03.02.1999
(51) Int. Cl.: H01L 39/24

(54) **Process for the production of multi-layer composite conductors containing high transition temperature ceramic superconductors**

(30) Priority: 06.02.1998 IT MI980221
(71) Applicant: ENEL S.p.A., I-00198 Roma (IT)
(72) Inventor: Martini, Luciano, 20065 Inzago, (Milano) (IT)
(74) Representative: Mittler, Enrico

(57) **Abstract**

Process for the production of multi-layer composite conductor containing high transition temperature ceramic superconductor, comprising a first step in which a single electrically conductive thin metal sheet (3), is cut into the desired shape and it is then folded, through mechanical deformation, in order to form flat bellows, a second step in which the thin bellows folds (3) are filled with a superconductive ceramic powder (4), and finally a third step in which said flat bellows, containing the superconductive ceramic powder (4) inside of them, undergo a mono-axial pressing in such a way so as to bring the sides of the flat bellows one next to the other, thus enclosing within them the superconductive ceramic powder (4).

## Description

The present invention concerns a process for the production of multi-layer composite conductors containing high transition temperature ceramic superconductors (HTTS).

Superconductors are materials whose electric and magnetic characteristics undergo a sudden variation in the instance of the cooling of the material below a characteristic temperature of the material itself, that is generically indicated by the term of transition temperature or critical temperature (T_{C}).

As for what concerns electric characteristics, the reaching of the transition temperature produces a sudden annulment of the typical resistivity of the material, so that the material is able to transport extremely high electric currents with a negligible dissipation effect. The superconductivity condition is maintained until the temperature remains below the transition temperature and it can in addition be eliminated by means of application of an external magnetic field having an intensity higher than a critical transition value, that is also characteristic of the material.

It is quite evident that the possibility to develop the knowledge regarding superconductors in terms of application, especially for what concerns the transport of electric current, imposes the use of materials which have a transition temperature as high as possible.

Such possibility is in particular provided by ceramic superconductor materials whose transition temperature is around 125 °K, that is -148 °C, while traditional superconductors operate only at temperatures below 25 °K.

The known techniques for the production of electric conductors containing high transition temperature superconductive ceramic materials allow to obtain single or multi-wire cables in which one or more wires or strips of superconductor ceramic material, separate from each other, are externally coated with a containment structure. The material forming such containment structure, for example silver, must have chemical characteristics such as to prevent possible reactions with the ceramic powder and electric characteristics such as to allow the conduction of high electric currents even in the absence of superconductivity.

The production of such conductors is carried out utilising ceramic powders that are inserted inside said containing structure and subsequently pressed in order to obtain a good cohesion between ceramic powder grains. The aforesaid cohesion is obtained by means of heat processes.

In the power energy field in which it is necessary to obtain HTTS superconductive conductors with high properties for the transport of electric current it is necessary to reach high compaction densities and high degrees of orientation of the lamellar grains of the superconductor ceramic material, through repeated processes of pressing and/or rolling or melting and subsequent slow directional solidification.

In particular, HTTS/Ag composite strips with the best electric properties have very reduced thicknesses (for example below 0.3 mm), they can have mono-wire, multi-wire or concentric configuration, but generally they contain a high fraction of metallic material (Ag) and in addition, because of the consequent reduced quantity of superconductive material that is present in their cross section, they do not allow the transport of high electric currents (for example I<100A at 77 °K, in the absence of magnetic field). For applications involving the transport of electric power the assembly of several individual strips parallel to each other is therefore necessary in order to obtain an increase in the cross section of the superconductive material, even if this can imply some problems with the redistribution of the electric current through the section of the final conductor and in addition the assembly of the single strips is not easily achievable, especially in relation to the geometry of the same conductors, which are extremely long and thin.

The problems associated with the presence of a high fraction of metallic material (resistive silver matrix) inside the HTTS/Ag composite strip, concern also the larger dimensions of the same conductor and their respective cost.

The realisation of HTTS superconductive conductors for high currents (for example I>>500 A at 77 °K) can be done in different ways: by assembling HTTS strands or fibres that have been obtained with different preparation techniques, by assembling HTTS/silver composite strands obtained with the powder-in-tube technique, or by producing HTTS conductors with tubular or cylindrical shape by means of melting processes.

In literature (see Martini L. et al. Supercond. Sci. Technol. 1994 e Proc. 16^{th} ICEC 1996), a process is already known for the fabrication of multi-layer HTTS/Ag superconductive conductors using a superconductive ceramic powder having a bismuth base nominal composition and containing strontium, calcium, copper and oxygen (BSCCCO powder), in such a way that, owing to the lamellarity of their grains, the thin layers of this powder have as a result higher critical current densities, since they are better oriented. Such conductors are indicated as Bi-2223/Ag multi-layer conductors, in relation to their stoichiometric composition (Bi,Pb)₂ Sr₂ Ca₂ Cu₃ O_{y}.

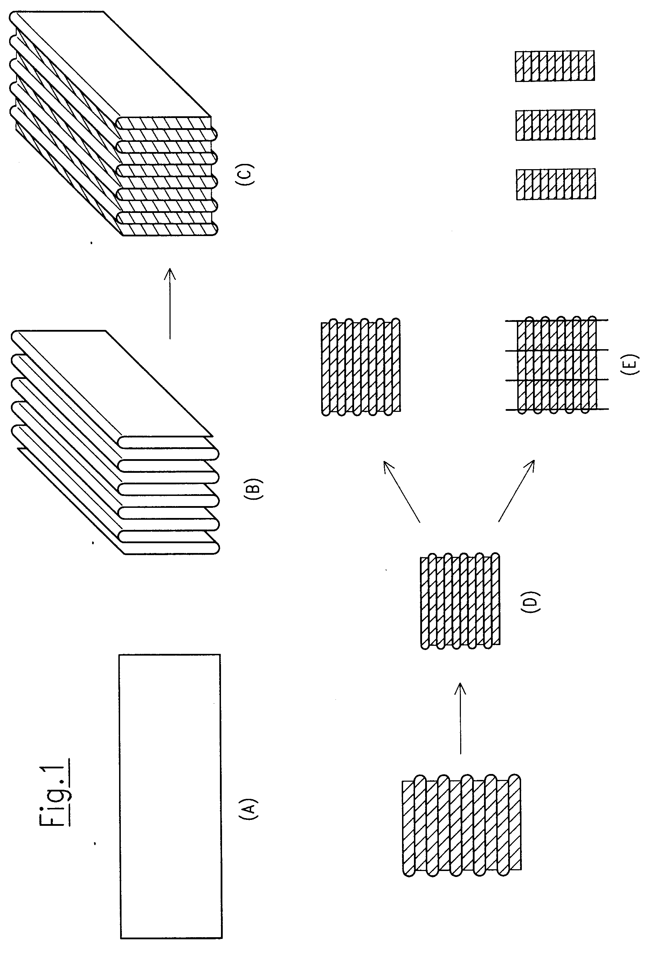

The process, called "accordion folding method", is schematised in Figure 1 and it starts with the mechanical deformation (folding) of a thin layer of silver 1 (phase A) in order to obtain flat bellows ("accordion") of the desired dimensions (phase B). The ceramic powder is then accurately inserted inside the recesses or grooves of the same bellows (phase C) and subsequently, by means of mono-axial pressing, the sides of the bellows are brought close to each other in order to enclose the ceramic powder within them (phase D). The product thus obtained can subsequently be submitted to sintering heat treatments at high temperature (in any case lower than the melting temperature of the metallic support) in order to realise a better electric connection among HTTS powder grains. Through possible subsequent pressing or rolling and heat treatment cycles, the thickness of the multi-layer strip can be further reduced thus obtaining simultaneously an enhanced density of the ceramic layer, a higher orientation of lamellar ceramic grains and the lengthening of the conductor cable.

In this way, a strip is obtained which has numerous thin layers of HTTS ceramic material (for example BSCCO powder), having characteristics of a good orientation and structural alignment in addition to a high density of the ceramic material, and that are separated from each other by layers of silver.

Once the various Bi-2223/Ag multi-layer conductor strips have been obtained, each one having the desired dimensions (it is possible to carry out cutting operations on the various strips, phase E), these can be assembled together in order to create a structure suitable to the pre-fixed scope.

For example, a typical application of the superconductor electric conductors is to be employed in the realisation of current feedthrough or cascade leads (CURRENT LEAD) for an electric connection suitable to the transport of electric current between an electric terminal (for example at a temperature of 77 °K) and a superconductive device operating at low temperatures (for example a superconductive magnet immersed into a cryogenic bath of liquid helium at 4,2 °K), since they add the advantage of having the null resistance of the superconductors (absence of Joule effect) with the low thermal conductivity of the ceramic materials as compared with metals. Such current lead is utilised limitedly at lower temperatures and at the critical temperature T_{C}.

The dissipations of a superconductive current lead are in fact formed by a first contribution (Q_{conduction}) that is directly proportional to the cross section and inversely proportional to the length of the lead, which is small if compared with the one associated with an equal section of metallic material, and by a second contribution (Q_{contacts}) due to the dissipations present at the external contacts.

If the metal fraction (silver) that is coating the HTTS material is excessive and/or it has a high thermal conductivity, the first contribution Q_{conduction'} becomes too high and it is therefore necessary to resort to a fabrication process that would supply a final product with a determined shape having variable section, and optimised so as to take advantage of the entire HTTS material. In this way, it is possible to save HTTS material (at present very expensive) and silver and at the same time, by reducing the area of the same lead though keeping the same of length, the input of heat, which depends on the thermal conductivity of the lead, in the cooling bath, thus obtaining a minor consumption of the latter.

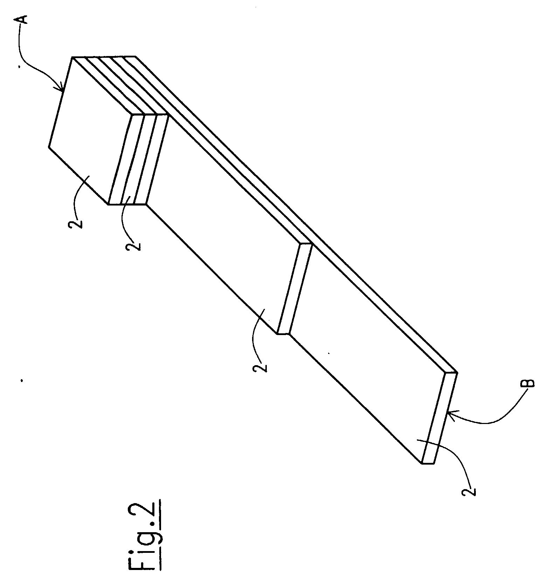

In order to solve such drawback, Bi-2223/Ag multi-layer conductor strips are created with the aforesaid process, "accordion folding method", each one having the desired dimensions, and subsequently these strips are assembled by means of welding operations of the two extreme sides of the silver resistive matrix of each strip, in order to obtain a current lead with a variable section structure (Figure 2). The side of the lead with the larger cross section (A) will be placed in contact with the electric terminal with higher temperature (for example between 60 and 80 °K) while the side with the smaller cross section (B)will be connected to the device that operates at a low temperature (for example immersed in the liquid helium cryogenic bath): calculations bring out that a relationship between cross section in contact with the mean at higher temperature and cross section in contact with the mean at lower temperature A/B=4-5 allows a reduction of the liquid helium consumption due to ebullition equal to about 50%.

The material forming the sheet from which the bellows are produced can be made, for example, of Ag-Au, 0.5%<Au<15% at. alloys, or nickel or steel coated with a thin layer of Ag or one of its alloys, in order to have a lower thermal conductivity than pure silver, so as to reduce the aforesaid drawbacks, taking into account that it must not have properties such as to cause chemical reactions with the ceramic powder during possible high temperature heat treatments.

A drawback that can make the high transport capacity conductor (I>1 kA) unserviceable consists in the dissipation due to the joule effect that is present at the terminals of the same Q_{contacts} conductor, which must therefore be made in an adequate manner.

The assembly of the various Bi-2223/Ag conductors strips, for example by means of welding of the same, in order to obtain the final structure with variable section, creates problems of qualitative degradation of the entire conductor.

In view of the state-of-the-art herein described, an object of the present invention is to provide for a process for the realisation of multi-layer composite conductors containing High Transition Temperature ceramic Superconductors (HTTS), capable to solve the aforementioned drawbacks.

According to the present invention, such object is attained by means of a process for the production of multi-layer composite conductor containing a high transition temperature ceramic superconductor, characterised by comprising:
a first step in which a single, electrically conductive thin metal sheet, is cut into the desired shape and then folded, through mechanical deformation, in order to obtain flat bellows;
a second step in which the flat bellows folds are filled with a superconductive ceramic powder;
a third step in which the flat bellows, containing the superconductive ceramic powder within them, undergo a mono-axial pressing in order to bring the sides of this flat bellows one next to the other, thus enclosing the superconductive ceramic powder inside of them.

It is quite evident that a finished product is in this way obtained in which there is no need for cutting and subsequent welding operations of the single multi-layer conductors in order to obtain the desired shape, for example with variable section. In addition, by avoiding welding operations, the risks of superconductive material degradation are reduced.

As for what concerns the material forming the metallic sheet it is opportune for it to have a low thermal conductivity, especially at low temperatures (T<80 °K), in order to reduce the flow of heat from one end to the other: instead of pure silver it is therefore preferable to use Ag-Au, 0.5%<Au<15% alloys, or nickel or steel coated with a thin layer of silver or one of its alloys.

Characteristics and advantages of the present invention will become evident from the following detailed description of an embodiment thereof, that is illustrated as a non-limiting example in the enclosed drawings, in which:
Figure 1 schematically shows the different steps of a known process, for the realisation of conductor strips for the transport of high currents;
Figure 2 shows in tridimensional view a current lead with a variable section structure, realised through the process represented in Figure 1;
Figure 3 shows in plan and in a schematic cross section some of the possible initial shapes, at the beginning of the folding stage, of the pre-cut metal sheet according to the present invention;
Figure 4 shows the tridimensional structure of a multi-layer composite conductor, that has been obtained according to an embodiment of the present invention; and
Figures 5 and 6 show cross sections of a multi-layer composite conductor with respective electric terminations, according to two embodiments of the present invention.

Figure 2 shows in tridimensional view a current lead with a variable section structure, realised through the process named "accordion folding method" and shows in its main realisation step in Figure 1. The various blocks 2 making up such structure each represent a multi-layer composite conductor that has been obtained through the aforementioned realisation process. The different dimensions of the various blocks 2 are realised by means of cutting operation of the conductors strips during the final step of the fabrication process and the assembly of the blocks so as to form the finished product is done by means of welding of ends of the same, one to each other.

A structure of this kind, with variable cross section, can be employed as a current lead in which the side having larger section (A) has to be put in contact with the higher temperature electric terminal while the side having smaller section (B) has to be connected with the low temperature superconductive device.

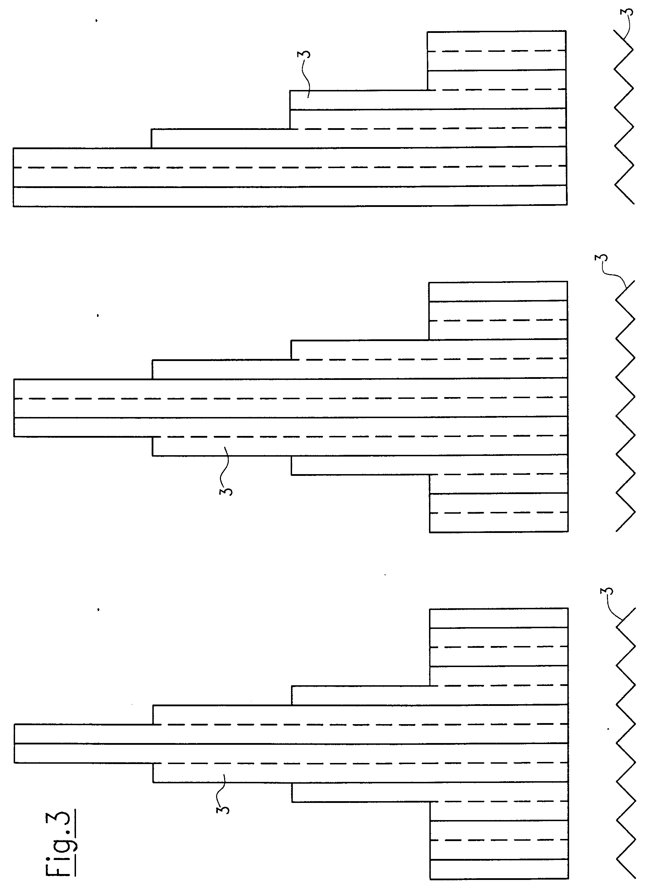

Figure 3 shows some of the possible initial shapes, at the beginning of the folding step, of the pre-cut metal sheet according to the present invention. In the initial step of the process according to the present invention, starting from metal sheets 3, shapes thereof with variable width from one end to the other are realised by cutting: in this way a structure ready to be used as a resistive matrix of the HTTS multi-layer composite conductor is obtained avoiding operations of cutting and assembly of the various conductors, with the relative welding of the same and degradation of the final product.

The metal sheet is preferably made of a low heat conductivity material, especially for low temperatures, in order to prevent the flow of heat from one end to the other, as for example Ag-Au, 0.5%<Au<15% alloys, or nickel or steel coated with a thin layer of silver or one of its alloys.

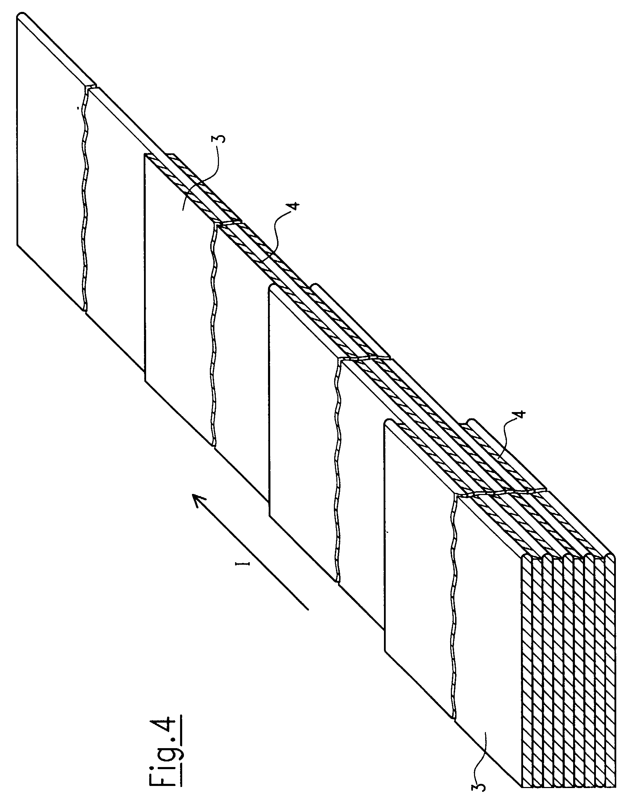

Figure 4 shows the tridimensional structure of a multi-layer composite conductor, that has been obtained according to an embodiment of the present invention. The structure has a variable cross section that can be used as a current lead: it is formed by metal support obtained from an initial single sheet 3, that is contoured in an adequate manner according to Figure 3, then folded as bellows with its folds filled with HTTS ceramic powder 4 and finally pressed in such a way so as to have characteristics of good orientation, alignment and high density of its lamellar grains, so as to optimise the electric conduction of the entire device.

The HTTS superconductive ceramic powder 4 is preferably a bismuth base nominal composition containing strontium, calcium, copper and oxygen (BSCCO powder), in such a way that, owing to the lamellarity of their grains, the thin layer of this powder have as a result higher critical current densities, because they are better oriented.

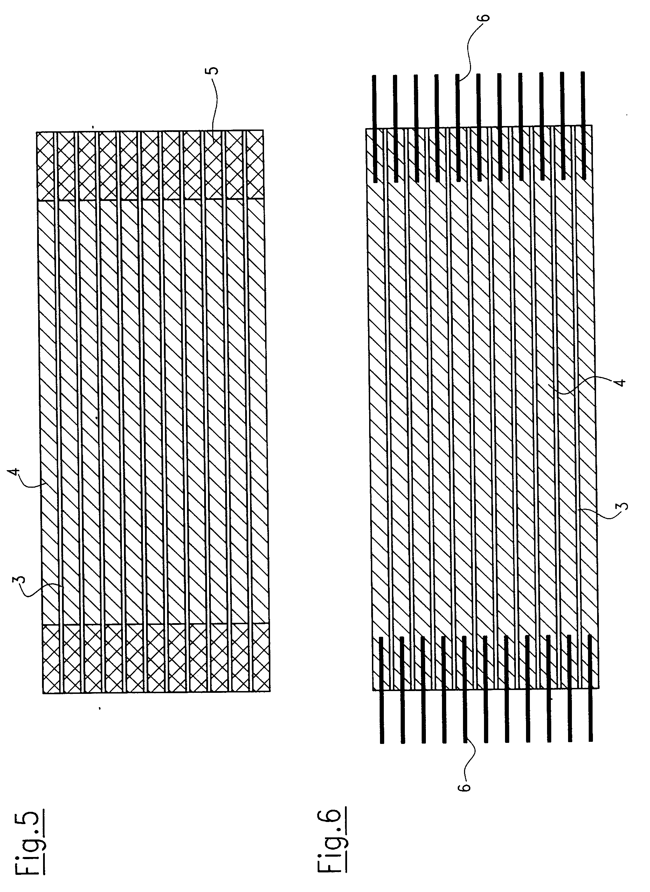

Figures 5 and 6 show the cross-sections of a multi-layer composite conductor comprising respective electric terminations, according to two embodiments of the present invention.

In order to obtain a structure suitable to house the respective terminals, it is necessary to operate in such a way that the HTTS ceramic powder, during the filling stage of the flat bellows metallic support, occupies only partially the space available within the recesses of the same bellows, so that the ends of the conductor are, through the use of conductive powders 5 (for example metallic Ag powders) or conductive strips 6 ( for example thin metal strips), predisposed for the realisation of electric connections (terminations) between the conductor itself and the other components of the electric circuit. The terminations of the multi-layer conductor can be realised in the aforesaid ways or by positioning metal blocks having appropriate geometry in correspondence of the ends of the same conductor, before the final heat treatment so as to realise an intimate thermal and electric contact, the latter necessary for the realisation of low electric resistance connections.

## Claims

1. Process for the production of multi-layer composite conductor containing a high transition temperature ceramic superconductor, characterised by comprising:
a first step in which a single electrically conductive thin metal sheet (3), that is, is cut into the desired shape and then folded, through mechanical deformation, in such a way so as to obtain flat bellows;
a second step in which said thin bellows folds (3) are filled with a superconductive ceramic powder (4);
a third step in which said flat bellows, containing the superconductive ceramic powder (4) within them, undergo a mono-axial pressing in order to bring the sides of these flat bellows one next to the other, enclosing inside of them the superconductive ceramic powder (4) in the form of thin layers, with characteristics of good structural orientation and alignment and in addition of high density of said ceramic powder.

2. Process according to claim 1, characterised in that said thin metal layer (3) has a longitudinal extension equal to the one of the conductor to be realised and a variable width from one end of said longitudinal extension to the other.

3. Process according to claim 3, characterised in that said second step is carried out in such a way that the folds of said thin metal sheet (3) are then filled only partially with said superconductive ceramic powder (4) in such a way that at the ends of said multi-layer composite conductor there is space available for the introduction of conductive powder (5), suitable to realise electric terminations for external connections.

4. Process according to claim 3, characterised in that said conductive powder (5) consists of metallic silver powder.

5. Process according to claim 2, characterised in that said second step is carried out in such a way that the folds of said thin metal sheet (3) are then filled only partially with said superconductive ceramic powder (4) in such a way that at the ends of said multi-layer composite conductor there is space available for the introduction of conductive strips (6), suitable to realise electric terminations for external connections.

6. Process according to claim 3, characterised in that said conductive strips (6) consist of metal strips.

7. Process according to any one of claims from 1 to 6, characterised in that said metal sheet (3) is made of pure silver.

8. Process according to any one of claims from 1 to 6, characterised in that said metal sheet (3) is made of a material having a low thermal conductivity as compared with pure silver.

9. Process according to claim 8, characterised in that said metal sheet (3) is made of a silver alloy.

10. Process according to claim 9, characterised in that said silver alloy is Ag-Au, 0.5%<Au<15%.

11. Process according to claim 8, characterised in that said metal sheet (3) is made of nickel coated with a layer of silver.

12. Process according to claim 8, characterised in that said metal sheet (3) is made of nickel coated with a layer of silver alloy.

13. Process according to claim 8, characterised in that said metal sheet (3) is made of steel coated with a layer of silver.

14. Process according to claim 8, characterised in that said metal sheet (3) is made of steel coated with a layer of silver alloy.

15. Process according to any one of claims from 1 to 14, characterised in that said superconductive ceramic powder (4) consists of a bismuth base nominal composition and containing strontium, calcium, copper and oxygen (BSCOO powder).

16. Process according to any one of claims from 1 to 15, characterised in that said metallic sheet (3) is contoured in such a way that said multi-layer composite conductor, once finished, assumes a complex structure having a variable cross section.

17. Multi-layer composite conductor obtained through the process according to any one of the previous claims, characterised in that it is made of a single metal sheet (3) with variable length folded into bellows and transversally pressed so as to generate a complex structure having a variable cross section, with fillings of superconductive ceramic powder (4) inserted into the bellows folds.

18. Multi-layer composite conductor according to claim 17, characterised in that said metal sheet (3) is made of pure silver.

19. Multi-layer composite conductor according to claim 17, characterised in that said metal sheet (3) is made of a material having a low thermal conductivity as compared with pure silver.

20. Multi-layer composite conductor according to claim 19, characterised in that said metal sheet (3) is made of a silver alloy.

21. Multi-layer composite conductor according to claim 19, characterised in that said silver alloy is Ag-Au, 0.5%<Au<15%.

22. Multi-layer composite conductor according to claim 18, characterised in that said metal sheet (3) is made of nickel coated with a layer of silver.

23. Multi-layer composite conductor according to claim 19, characterised in that said metal sheet (3) is made of nickel coated with a layer of silver alloy.

24. Multi-layer composite conductor according to claim 20, characterised in that said metal sheet (3) is made of steel coated with a layer of silver.

25. Multi-layer composite conductor according to claim 21, characterised in that said metal sheet (3) is made of steel coated with a layer of silver alloy.

26. Multi-layer composite conductor according to any one of claims from 17 to 25, characterised in that said superconductive ceramic powder (4) consists of a bismuth base nominal composition and containing strontium, calcium, copper and oxygen (BSCOO powder).

27. Multi-layer composite conductor according to any one of claims from 17 to 26, characterised in that said bellows folds are filled only partially with said superconductive ceramic powder (4) while their ends are filled with conductive powder (5), suitable to realise electric terminations for external connections.

28. Multi-layer composite conductor according to claim 27, characterised in that said conductive powder (5) consists of metallic silver powder.

29. Multi-layer composite conductor according to any one of claims from 17 to 26, characterised in that said bellows folds are filled only partially with said superconductive ceramic powder (4), while conductive strips (6) are inserted at their ends, that are suitable to realise electric terminations for external connections.

30. Multi-layer composite conductor according to claim 29, characterised in that said conductive strips (6) are made of metal strips.
